# EUROPEAN PATENT APPLICATION

(11) **EP 3 162 860 A1**
(43) Date of publication of application: **03.05.2017**
(21) Application number: 15811971.9
(22) Date of filing: 26.06.2015
(51) Int. Cl.: C09B 67/22, G03F 7/00, G02B 5/20

(54) **PHOTOSENSITIVE RESIN COMPOSITION AND COLOR FILTER USING SAME**

(30) Priority: 27.06.2014 KR 20140079672
(71) Applicant: LG Chem, Ltd., Seoul 150-721 (KR)
(72) Inventor: YANG, Seung Jin, Daejeon 305-738 (KR); KIM, Nari, Daejeon 305-738 (KR); LEE, Ki Youl, Daejeon 305-738 (KR); CHOI, Kyung Soo, Daejeon 305-738 (KR); YOO, Sang Moon, Daejeon 305-738 (KR)
(74) Representative: Goddar, Heinz J.
(86) International application number: PCT/KR2015/006549
(87) International publication number: WO 2015/199485

(57) **Abstract**

The present application relates to a photosensitive resin composition and a color filter using the same. If the photosensitive resin composition provided in the present application is used, since a color deeper than that of the related art can be implemented, in various thickness ranges of a color filter, color reproducibility may be increased and a contrast ratio may be increased.

## Description

### [Technical Field]

This application claims priority to and the benefit of Korean Patent Application No. 10-2014-0079672 filed in the Korean Intellectual Property Office on June 27, 2014, the entire contents of which are incorporated herein by reference.

The present application relates to a photosensitive resin composition and a color filter using the same.

### [Background Art]

In general, a color filter is used in order to implement a color image in a display device, and may be manufactured through a process of applying a pigment on a substrate as a base by using various methods, followed by curing and patterning.

The aforementioned color filter may be formed by an electrodeposition method, a printing method, a pigment dispersion method (photolithography method using a photopolymer where a pigment is dispersed), or a dyeing method (dyeing method of a photopolymer pattern).

The electrodeposition method has a decisive problem in terms of uniform arrangement of pixels and enlargement of the substrate due to non-uniformity of a peripheral shape of an electrode, and the printing method is hardly used because it is difficult to perform alignment at a precise position with respect to a liquid crystal cell, and accurately form a pattern, and the printing method is not suitable for a thickness reduction and resolution of a film and enlargement of the substrate.

The dyeing method has merits such as accuracy in formation of a pattern, high light transmittance, and high color purity, but has problems of poor heat resistance, light resistance, and chemical resistance, which cause color fading of a dye or vaporization of the dye.

On the other hand, since the pigment dispersion method does not have the aforementioned problems, the pigment dispersion method is considered most suitable among the methods in the art, and thus recently, the pigment dispersion method has been mostly used as a method of manufacturing the color filter.

The pigment dispersion method refers to a method of precisely forming a pattern of a color resist, in which pigments showing red, green, and blue colors are dispersed in a photosensitive material, for every pixel P within an error range by using a photo-lithography method.

In this case, the color resist may be uniformly applied on a substrate by a spin coating method, a portion to be exposed and a non-exposed portion may be classified by using a photo-mask, the exposed portion may be solidified by irradiating rays such as ultraviolet rays, and the non-exposed portion may be removed by using a developing solution, thereby obtaining a color filter pattern.

In this case, the pigments showing the red, green, and blue colors are formed of fine particles, that is, pigments, and in order to allow the pigment to have a color display property of a desired region, the pigment is not used alone but the pigments having colors that are similar to each other are mixed to show the red, green, and blue colors.

### [Detailed Description of the Invention]

### [Technical Problem]

In the corresponding technical field, there is a need for research for a photosensitive resin composition capable of exhibiting a superior effect and manufacturing a color filter by a simple process.

### [Technical Solution]

The present application provides a photosensitive resin composition including: a first binder resin, an acrylate-based compound, a photopolymerization initiator, a first solvent, and a colorant composition, in which the colorant composition includes a green colorant, a yellow colorant represented by the following Chemical Formula 1, and a blue dispersing aid.

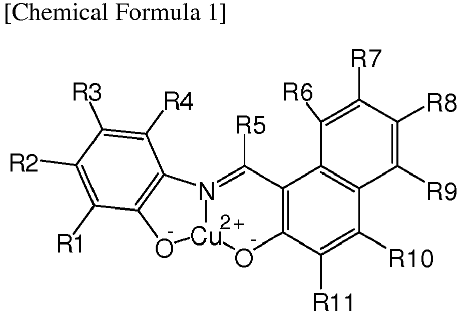

In Chemical Formula 1,
R1 to R11 are the same as or different from each other, and are each independently selected from the group consisting of hydrogen, deuterium, a halogen group, a substituted or unsubstituted alkyl group, a substituted or unsubstituted alkoxy group, a substituted or unsubstituted cycloalkyl group, a substituted or unsubstituted aryl group, and a substituted or unsubstituted heterocyclic group.

Further, the present application provides a color filter formed by using the photosensitive resin composition.

### [Advantageous Effects]

If a photosensitive resin composition provided in the present application is used, since a color that is deeper than that of the related art is implemented, in various thickness ranges of a color filter, it is possible to increase color reproducibility and increase a contrast ratio.

Particularly, according to the present application, by including a green colorant, a yellow colorant, and a blue dispersing aid together in a colorant composition, it is possible to improve a coloring ability of the green colorant and thus implement a deep color.

Further, according to the present application, since the coloring ability of the green colorant is improved, it is possible to reduce a content of the colorant and secure a process margin.

### [Brief Description of Drawings]

FIG. 1 is a view illustrating a color coordinate (Gx, Gy) of a color filter pattern according to Example 1 of the present application.
FIG. 2 is a view illustrating a relationship between the color coordinate Gy and luminance GY of the color filter pattern according to Example 1 of the present application.

### [Best Mode]

Hereinafter, the present application will be described in more detail.

In the present application, the colorant means a pigment, a dye, and the like.

As described above, a color filter pattern may be manufactured by uniformly applying a color resist, in which colorants showing red, green, and blue colors are dispersed in a photosensitive material (binder), on a substrate by a spin coating method, solidifying a portion exposed by irradiating rays such as ultraviolet rays by using a photo-mask, and removing a non-exposed portion by using a developing solution.

In this case, the colorants showing the red, green, and blue colors may be formed of fine particles, that is, pigments, and in order to allow the colorant to have a color display property of a desired region, the colorant is not used alone but the colorants having colors that are similar to each other are mixed to show the red, green, and blue colors.

Particularly, as the colorant used in order to form a green color filter pattern, a pigment Green 7, a pigment Green 36, or a pigment Green 58, and a pigment Yellow 138 or a pigment Yellow 150 are generally used while being mixed.

However, a method of mixing and using the Green 7, the Green 36, or the Green 58, and the Yellow 138 or the Yellow 150 in order to form the green color filter pattern may have a problem in that a thickness of the color filter pattern is increased, and there is a limit in implementing a deep color in a range of about 2.0 to 2.5 µm which is the thickness of the color filter pattern required in the corresponding technical field.

Therefore, the present inventors have conducted research for a photosensitive resin composition, which may implement a color that is deeper than that of the related art, and thus, in various thickness ranges of the color filter, may increase color reproducibility and a contrast ratio, and a color filter using the same.

The photosensitive resin composition according to an exemplary embodiment of the present application includes a first binder resin, an acrylate-based compound, a photopolymerization initiator, a first solvent, and a colorant composition, and the colorant composition includes a green colorant, a yellow colorant represented by Chemical Formula 1, and a blue dispersing aid.

The dispersing aid is used while being mixed with a dispersant and an acryl-based binder to uniformly disperse the colorant, and a basic aid, an acidic aid, and a neutral aid, specifically, phthalocyanines, quinacridones, anthraquinones, dioxanes, and quinophthalones, and the like may be used, but a use thereof may be limited according to a color and a property of each colorant. Particularly, generally, the phthalocyanine-based dispersing aid is mostly used in dispersion of the red and blue colorants, the thraquinone-based dispersing aid is mostly used in dispersion of the red and yellow colorants, the dioxane-based dispersing aid is mostly used in dispersion of the red and blue colorants, and the phthalocyanine-based dispersing aid is mostly used in dispersion of the blue and green colorants, but the dispersing aid is not limited thereto.

Particularly, in the colorant composition including the green and yellow colorants in the related art, the yellow dispersing aid is applied, but the colorant composition according to the exemplary embodiment of the present application may include the blue dispersing aid to further increase a coloring ability of the colorant composition.

In the exemplary embodiment of the present application, as the blue dispersing aid, a copper phthalocyanine-based compound may be used. In the present application, the blue dispersing aid may be included in the colorant composition to effectively absorb a long wavelength region in a green spectrum and thus significantly reduce a content of the green colorant. Further, in the related art, in consideration of luminance of the color filter pattern, the green dispersing aid is used as the dispersing aid using the copper phthalocyanine-based compound, but in the present application, the blue dispersing aid may be used as the dispersing aid using the copper phthalocyanine-based compound to improve the coloring ability of the green colorant and thus implement a deep color.

In the present application, the copper phthalocyanine-based blue dispersing aid has a structure not including a halogen group, like a Blue15:6 pigment, and the copper phthalocyanine-based green dispersing aid has a structure including the halogen group, like G7. Basically, the dispersing aid provides an ionic group in the same structure as a main pigment to perform modification into a structure advantageous to dispersion. Even if the blue dispersing aid is not added but the blue colorant is added to the green colorant, a similar effect may be obtained in terms of the coloring ability, but the properties of the dispersing aid are modified to secure the structure advantageous to dispersion and thus reduce luminance, and thus it is advantageous to minimize an amount thereof. Therefore, in terms of luminance, it is advantageous to use a combination of the green colorant-blue dispersing aid rather than a composition of the green colorant-blue colorant-green dispersing aid.

In the present application, the colorant composition may further include one kind or more of a second binder resin, a dispersant, a second solvent, and the like.

In the present application, based on the total weight of the colorant composition, the total content of the green colorant, the yellow colorant represented by Chemical Formula 1, and the blue dispersing aid may be 12 to 15 wt%, but is not limited thereto.

In this case, based on the total content of the green colorant, the yellow colorant represented by Chemical Formula 1, and the blue dispersing aid, the content of the blue dispersing aid may be 5 to 20 wt%, but is not limited thereto.

As the second binder resin, the acryl-based binder resin may be used, but the second binder resin is not limited thereto. The acryl-based binder resin has a structure having a main chain (backbone) of an acryl structure, and an acryl-based binder including one kind single monomer or two kinds or more monomers of acrylate, methacrylate, methacrylic acid, and acrylic acid may be used. The acryl-based binder may be used in a content in a range of 0.1 to 50 wt%, preferably 1 to 40 wt%, and more preferably 1 to 5 wt%, in the colorant composition, and if a use amount thereof is less than the aforementioned range, an effect, which may be obtained by using the acryl-based binder, is not sufficiently implemented, and if the use amount thereof is more than the aforementioned range, a problem may occur in thermal curing, and thus it is preferable to maintain the aforementioned range.

The dispersant is used in order to uniformly disperse components constituting the colorant composition together with the acryl-based binder, and it is possible to use a dispersant having solubility with respect to an organic solvent generally used in the corresponding technical field and having compatibility with the acryl-based binder and the colorant, which are used together.

As a commercialized dispersant, a dispersant such as polyacryls, polyesters, and polyurethanes may be used, and as a dispersant available on the market, Disperbyk-110, 111, 180, 161, 163, 165, 166, 167, 2000, 2001, and 2163, LPN-21116, LPN-6919, LPN-21538, and LPN-21208, (BYK-chemie), PB-821, 822, and 880 (AJINOMOTO FINE TECHNO), solsperse 24000 (Lubrizol), and the like may be used alone or while being mixed.

As compared to the case where a content of a solid as the dispersant is 100 wt%, it is more preferable that polyacryl-based or polyester-based dispersants having an acid value of 40 mg KOH/g or less and an amine value of 60 to 130 mg KOH/g are used alone or while being mixed. This dispersant may be used in a content in a range of 0.1 to 40 wt% and preferably 1 to 5 wt%, in the colorant composition, and in this case, if a use amount thereof is less than the aforementioned range, dispersion is not sufficient, and if the use amount thereof is more than the aforementioned range, compatibility of the dispersant in the solvent is reduced, so that it is difficult to control dispersion stability, and thus the dispersant may be used by adjusting the content to the aforementioned range.

The second solvent can be used as long as the second solvent is an organic solvent capable of dissolving components constituting the colorant composition of the present application, and specifically, propylene glycol methyl ether acetate (PGMEA), propylene glycol methyl ether (PGME), ethyl-3-ethoxy propionate (EEP), cychohexanone, methyl ethyl ketone (MEK), methyl isobutyl ketone (MIBK), metoxy butyl acetate, and the like may be used.

This organic solvent is used in a content of 10 to 90 wt% and preferably 75 to 80 wt% in the colorant composition of the present application, and if a use amount thereof is less than the aforementioned range or is more than the aforementioned range, manufacturing yield is reduced.

In the exemplary embodiment of the present application, substituent groups of Chemical Formula 1 will be more specifically daaescribed below.

The alkyl group may be a straight or branched chain, and the number of carbon atoms of the alkyl group is not particularly limited, but may be 1 to 30. Specific examples thereof include a methyl group, an ethyl group, a propyl group, an isopropyl group, a butyl group, a t-butyl group, and the like, but are not limited thereto.

The alkoxy group may be a straight or branched chain, and the number of carbon atoms of the alkoxy group is not particularly limited, but may be 1 to 30.

The aryl group may be a monocycle or a polycycle, and the number of carbon atoms thereof is not particularly limited, but may be 6 to 60. Examples of the monocyclic aryl group include a phenyl group, a biphenyl group, a terphenyl group, a stilben group, and the like, and examples of the polycyclic aryl group include a naphthyl group, an anthracenyl group, a phenanthrenyl group, a pyrenyl group, a perylenyl group, a tetracenyl group, a chrysenyl group, a fluorenyl group, an acenaphthacenyl group, a triphenylene group, a fluoranthrene group, and the like, but the scope of the present invention is not limited to the examples.

The heterocyclic group is a heterocyclic group including O, N, or S as a heteroatom, and the number of carbon atoms thereof is not particularly limited, but may be 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a triazine group, an acridyl group, a pyridazine group, a quinolinyl group, an isoquinoline group, an indole group, a carbazole group, a benzoxazole group, a benzimidazole group, a benzthiazol group, a benzcarbazole group, a benzthiophene group, a dibenzothiophene group, a benzfuranyl group, a dibenzofuranyl group, and the like, but are not limited thereto.

The cycloalkyl group is not particularly limited, but the number of carbon atoms thereof may be 3 to 60. Specific examples include a cyclopentyl group, a cyclohexyl group, and the like, but the scope of the present invention is not limited to the examples.

Examples of the halogen group include fluorine, chlorine, bromine, or iodine.

Further, the photosensitive resin composition according to the exemplary embodiment of the present application includes the first binder resin, the acrylate-based compound, the photopolymerization initiator, the first solvent, and the colorant composition.

In the exemplary embodiment of the present application, as the first binder resin, an alkali-soluble resin known in the corresponding technical field may be used. Examples of the alkali-soluble resin may include an acryl-based resin including a carboxyl group, but are not limited thereto.

In the exemplary embodiment of the present application, the content of the first binder resin may be 20 to 80 wt% based on the total weight of a solid of the photosensitive resin composition. In the case where the content of the first binder resin is less than 20 wt%, a developing property may be reduced, and in the case where the content thereof is more than 80 wt%, the surface of the color filter pattern may be damaged to increase roughness.

In the exemplary embodiment of the present application, as the green colorant, green colorants known in the corresponding technical field may be used. Specific examples thereof may include a phthalocyanine green (C.I. 74260), a C.I. PIGMENT Green 7, and the like, but are not limited thereto.

In the exemplary embodiment of the present application, the yellow colorant may be represented by Chemical Formula 1. Specific examples of the yellow colorant may include a C.I. PIGMENT Yellow 129 and the like, but are not limited thereto.

In the exemplary embodiment of the present application, the total content of the green colorant and the yellow colorant may be 20 to 60 wt% based on the total weight of the solid of the photosensitive resin composition. Further, a weight ratio of the green colorant to the yellow colorant may be in a range of 1 : 9 to 9 : 1 and in a range of 2 : 8 to 8 : 2, but is not limited thereto.

In the exemplary embodiment of the present application, Gx and Gy of a color coordinate (Gx, Gy) of the color filter pattern manufactured by using the photosensitive resin composition may be in a range of 0.2 to 0.21 and 0.68 to 0.7, respectively. Further, Gx of the color coordinate (Gx, Gy) of the color filter pattern manufactured by using the photosensitive resin composition may be in a range of 0.19 to 0.21.

Further, a thickness of the color filter pattern manufactured by using the photosensitive resin composition may be 2.0 to 2.5 µm.

In the present application, examples of the acrylate-based compound may include one kinds or more selected from the group consisting of: a compound obtained by esterifying polyvalent alcohol, such as ethyleneglycol di(metha)acrylate, polyethylene glycol di(metha)acrylate in which the number of ethylene groups is 2 to 14, trimethylolpropane di(metha)acrylate, trimethylolpropane tri(metha)acrylate, pentaerythritol tri(metha)acrylate, pentaerythritol tetra(metha)acrylate, 2-trisacryloyloxymethylethyl phthalate, propylene glycol di(metha)acrylate in which the number of propylene groups is 2 to 14, dipentaerythritol penta(metha)acrylate, dipentaerythritol hexa(metha)acrylate, and a mixture of an acidic denatured material of dipentaerythritol penta(metha)acrylate and dipentaerythritol hexa(metha)acrylate (trademark: TO-2348 and TO-2349 manufactured by Toagosei Co., Ltd. in Japan), by a α,β-unsaturated carboxylic acid; a compound obtained by adding (metha)acrylic acid to a compound containing a glycidyl group such as an addition product of trimethylolpropane triglycidyletheracrylic acid and an addition product of bisphenol A diglycidyletheracrylic acid; an addition product of a hydroxyl group, such as diester phthalate of β-hydroxyethyl(metha)acrylate and an addition product of toluene diisocyanate of β-hydroxyethyl (metha)acrylate, or an addition product of an ester compound of a compound having an ethylenically unsaturated bond and polyvalent carboxylic acid, or polyisocyanate; (metha)acrylate alkylester such as methyl(metha)acrylate, ethyl(metha)acrylate, butyl(metha)acrylate, and 2-ethylhexyl(metha)acrylate; and 9,9'-bis[4-(2-acryloyloxyethoxy)phenyl]fluorene, but are not limited thereto, and general acrylate-based compounds known in the corresponding technical field may be used. In some cases, a silica dispersing element may be used in these compounds, and examples thereof include Nanocryl XP series (0596, 1045, 21/1364) and Nanopox XP series (0516, 0525) manufactured by Hanse Chemie Co., Ltd., and the like.

The content of the acrylate-based compound may be 15 to 75 wt% based on the total weight of the solid of the photosensitive resin composition, but is not limited thereto.

In the present application, as the photopolymerization initiator, a triazine-based compound such as 2,4-trichloromethyl-(4'-methoxyphenyl)-6-triazine, 2,4-trichloromethyl-(4'-methoxystyryl)-6-triazine, 2,4-trichloromethyl-(fipronil)-6-triazine, 2,4-trichloromethyl-(3',4'-dimethoxyphenyl)-6-triazine, 3-{4-[2,4-bis(trichloromethyl)-s-triazine-6-yl]phenylthio} propanoic acid, 2,4-trichloromethyl-(4'-ethylbiphenyl)-6-triazine, and 2,4-trichloromethyl-(4'-methylbiphenyl)-6-triazine; a biimidazole compound such as 2,2'-bis(2-chlorophenyl)-4,4',5,5'-tetraphenyl biimidazole, and 2,2'-bis(2,3-dichlorophenyl)-4,4',5,5'-tetraphenylbiimidazole; an acetophenone-based compound such as 2-hydroxy-2-methyl-1-phenylpropane-1-one, 1-(4-isopropylphenyl)-2-hydroxy-2-methylpropane-1-one, 4-(2-hydroxyethoxy)-phenyl (2-hydroxy)propyl ketone, 1-hydroxycyclohexyl phenyl ketone, 2,2-dimethoxy-2-phenyl acetophenone, 2-methyl-(4-methylthiophenyl)-2-morpholino-1-propane-1-one (Irgacure-907), and 2-benzyl-2-dimethylamino-1-(4-morpholinophenyl)-butane-1-one (Irgacure-369); an O-acyloxime-based compound such as Irgacure OXE 01 and Irgacure OXE 02 manufactured by Ciba Geigy Co., Ltd.; a benzophenone-based compound such as 4,4'-bis(dimethylamino)benzophenone, and 4,4'-bis(diethylamino)benzophenone; a thioxantone-based compound such as 2,4-diethyl thioxantone, 2-chloro thioxantone, isopropyl thioxantone, and diisopropyl thioxantone; a phosphine oxide-based compound such as 2,4,6-trimethylbenzoyl diphenylphosphine oxide, bis(2,6-dimethoxybenzoyl)-2,4,4-trimethylpentyl phosphine oxide, and bis(2,6-dichlorobenzoyl) propyl phosphine oxide; a coumarine-based compound such as 3,3'-carbonylvinyl-7-(diethylamino)coumarine, 3-(2-benzothiazolyl)-7-(diethylamino)coumarine, 3-benzoyl-7-(diethylamino)coumarine, 3-benzoyl-7-methoxy-coumarine, and 10,10'-carbonylbis[1,1,7,7-tetramethyl-2,3,6,7-tetrahydro-1H,5H,11H-Cl]-benzopyrano[6,7,8-ij]-quinolizine-11-one, and the like may be used alone or in a mixture of two or more.

The content of the photopolymerization initiator may be 0.1 to 5 wt% based on the total weight of the solid of the photosensitive resin composition, but is not limited thereto.

In the present application, the solvent may include one kind or more selected from the group consisting of methyl ethyl ketone, methyl cellosolve, ethyl cellosolve, ethyleneglycol dimethyl ether, ethyleneglycol diethyl ether, propyleneglycol dimethyl ether, propyleneglycol diethyl ether, diethyleneglycol dimethylether, diethyleneglycol diethylether, diethyleneglycol methyl ethyl ether, 2-ethoxy propanol, 2-methoxy propanol, 3-methoxy butanol, cyclohexanone, cyclopentanone, propyleneglycol methyl ether acetate, propyleneglycol ethyl ether acetate, 3-methoxybutyl acetate, ethyl 3-ethoxypropionate, ethyl cellosolveacetate, methyl cellosolveacetate, butyl acetate, and dipropyleneglycol monomethyl ether, but is not limited thereto.

The photosensitive resin composition according to the exemplary embodiment of the present application may further include one kind or more of a light blocking agent, a curing accelerator, a thermal polymerization inhibitor, a surfactant, a photosensitizer, a plasticizer, an adhesion promotor, and a filler.

Examples of the curing accelerator may include one kind or more selected from the group consisting of 2-mercaptobenzoimidazole, 2-mercaptobenzothiazole, 2-mercaptobenzoxazole, 2,5-dimercapto-1,3,4-thiadiazole, 2-mercapto-4,6-dimethylaminopyrydine, pentaerythritol tetrakis(3-mercaptopropionate), pentaerythritol tris(3-mercaptopropionate), pentaerythritol tetrakis(2-mercaptoacetate), pentaerythritol tris(2-mercaptoacetate), trimethylolpropane tris(2-mercaptoacetate), trimethylolpropane tris(3-mercaptopropionate), trimethylolethane tris(2-mercaptoacetate), and trimethylolethane tris(3-mercaptopropionate), but are not limited thereto, and may include matters that are generally known in the corresponding technical field.

Examples of the thermal polymerization inhibitor may include one kind or more selected from the group consisting of p-anisole, hydroquinone, pyrocatechol, t-butyl catechol, a N-nitrosophenylhydroxyamine ammonium salt, a N-nitrosophenylhydroxyamine aluminum salt, and phenothiazine, but are not limited thereto, and may include matters that are generally known in the corresponding technical field.

Among materials used as an additive, all compounds, which may be included in a photosensitive resin composition in the related art, may be used as the surfactant, the photosensitizer, the plasticizer, the adhesion promoter, the filler, and the like.

The photosensitive resin composition according to the exemplary embodiment of the present application is used in a roll coater, a curtain coater, a spin coater, a slot die coater, various printings and precipitations, and the like, and may be applied onto a support of metal, paper, glass, and plastic substrates, and the like. Further, after being applied on the support such as the film, the composition may be transferred onto another support, or the composition is capable of being applied on a first support, transferred on a blanket and the like, and then transferred on a second support, and an application method thereof is not particularly limited.

Examples of a light source for curing the photosensitive resin composition of the present application include a mercury vapor arc, a carbon arc, and a Xe arc emitting light having a wavelength of 250 to 450 nm, and the like, but are not limited thereto.

Further, the present application provides a color filter formed by using the photosensitive resin composition.

The photosensitive resin composition according to the exemplary embodiment of the present application may be preferably used as a green color filter pattern in a liquid crystal display element of a thin film transistor.

The thickness of the green color filter pattern may be 2.0 to 2.5 µm. Further, Gx and Gy of the color coordinate (Gx, Gy) of the green color filter pattern may be in a range of 0.2 to 0.21 and 0.68 to 0.7, respectively. Further, Gx of the color coordinate (Gx, Gy) of the green color filter pattern may be in a range of 0.19 to 0.21. Particularly, Gy of the color coordinate (Gx, Gy) of the green color filter pattern is capable of implementing a deep color in a range of 0.68 to 0.7, and a contrast property is also excellent.

Hereinafter, preferable Examples will be proposed in order to help understanding of the present invention. However, the following Examples are set forth to illustrate the present invention, but the scope of the present invention is not limited thereto.

### <Example>

### <Example 1>

### 1) Manufacturing of colorant composition

The green colorant (C.I. PIGMENT Green 7), the yellow colorant (C.I. PIGMENT Yellow 129), the acryl binder (binder where benzyl methacrylate, methyl methacrylate, and methacrylic acid were copolymerized at the ratio of 5 : 3 : 2, Mw = 15,000), the blue dispersing aid (copper phthalocyanine-based compound), and propylene glycol monomethyl ether acetate were mixed to manufacture the colorant composition.

### 2) Manufacturing of photosensitive resin composition

The following photosensitive resin composition was manufactured in order to confirm the effect of the present application. 20 parts by weight of the alkali-soluble binder resin, 18 parts by weight of dipentaerythritol hexaacrylate as the acrylate compound, 5 parts by weight of OXE-022 manufactured by BASF Company as the photopolymerization initiator, 20 parts by weight of the colorant composition, and PGMEA as the organic solvent were put so that the sum total was 100 parts by weight, and the solution mixed by using the shaker for 3 hours was then obtained by the filter of 5 µm to be used.

The photosensitive resin composition was applied by the spin coating method to form the uniform thin film, and then subjected to the pre-baking process at 100°C for 100 seconds to volatilize the solvent. Thereafter, exposure was performed under the high pressure mercury lamp by using the photomask having the square light blocking pattern having the width of 500 µm. The exposed substrate was developed by the spray manner in the 0.043% KOH aqueous solution at the temperature of 25°C, washed with pure water, and dried by air blowing. Thereafter, the substrate was left in the convection oven at 230°C for 20 minutes to form the color filter pattern.

### <Comparative Example 1>

The same procedure as Example 1 was performed, except that in Example 1, the C.I. PIGMENT Yellow 138 was used as the yellow colorant.

### <Comparative Example 2>

The same procedure as Example 1 was performed, except that in Example 1, the C.I. PIGMENT Yellow 139 was used as the yellow colorant.

### <Comparative Example 3>

The same procedure as Example 1 was performed, except that in Example 1, the C.I. PIGMENT Yellow 185 was used as the yellow colorant.

### <Comparative Example 4>

The same procedure as Example 1 was performed, except that in Example 1, the C.I. PIGMENT Green 58 was used as the green colorant.

### <Comparative Example 5>

The same procedure as Example 1 was performed, except that in Example 1, the C.I. PIGMENT Green 36 was used as the green colorant.

### <Comparative Example 6>

The same procedure as Example 1 was performed, except that in Example 1, the green dispersing aid (copper phthalocyanine-based compound) was used as the dispersing aid.

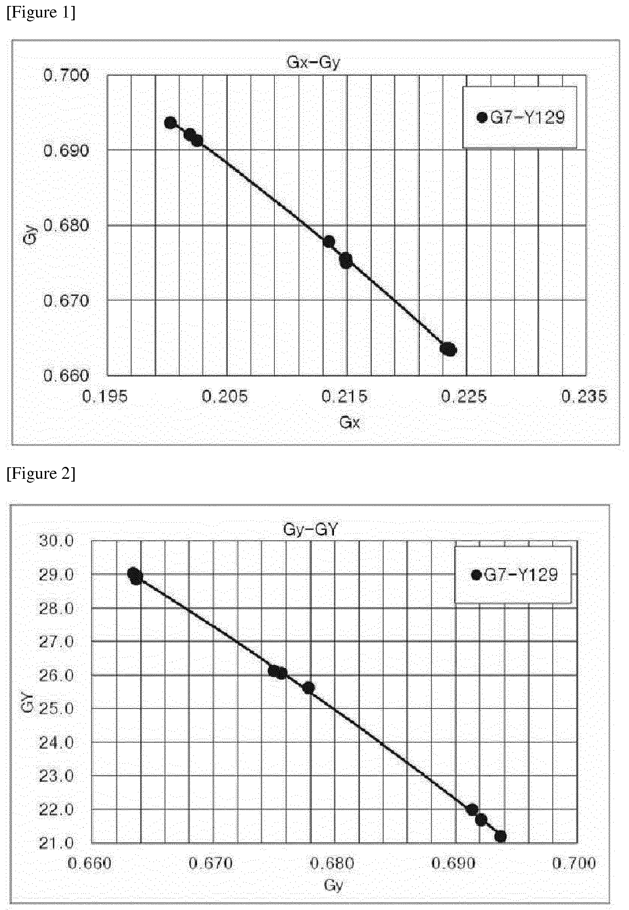

The color coordinate (Gx, Gy) of the color filter pattern according to Example 1 is illustrated in FIG. 1, and the relationship between the color coordinate Gy and luminance GY of the color filter pattern according to Example 1 is illustrated in FIG. 2.

Further, the thickness and the spectrum property of the color filter pattern when the color coordinates (Gx, Gy) of the color filter patterns of Example 1 and Comparative Examples 1 to 6 were adjusted to be the same as each other were evaluated, and the result is described in the following Table 1.

**[Table 1]**

| | Color coordinate | | Luminance (GY) | Thickness (µm) | Contrast |
|---|---|---|---|---|---|
| | Gx | Gy | | | |
| Example 1 | 0.210 | 0.680 | 25.5 | 2.5 | 10,000 |
| Comparative Example 1 | 0.210 | 0.680 | 31.0 | 4.5 | 12,000 |
| Comparative Example 2 | 0.210 | 0.680 | 20.5 | 2.2 | 1,000 |
| Comparative Example 3 | 0.210 | 0.680 | 27.5 | 2.3 | 500 |
| Comparative Example 4 | 0.210 | 0.680 | 26.5 | 3.5 | 10,000 |
| Comparative Example 5 | 0.210 | 0.680 | 23.5 | 3.8 | 8,000 |
| Comparative Example 6 | 0.210 | 0.680 | 26.0 | 3.0 | 10,000 |

As described above, only in the case where constituent components of the photosensitive resin composition according to the present application are included, the required thickness and spectrum property and the like may be satisfied.

That is, if the photosensitive resin composition provided in the present application is used, since a color deeper than that of the related art can be implemented, in various thickness ranges of the color filter, color reproducibility may be increased and a contrast ratio may be increased.

## Claims

1. A photosensitive resin composition comprising:
a first binder resin,
an acrylate-based compound,
a photopolymerization initiator,
a first solvent, and
a colorant composition,
wherein the colorant composition includes a green colorant, a yellow colorant represented by the following Chemical Formula 1, and a blue dispersing aid: 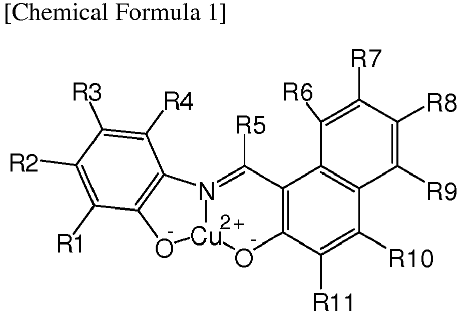
in Chemical Formula 1,
R1 to R11 are the same as or different from each other, and are each independently selected from the group consisting of hydrogen, deuterium, a halogen group, a substituted or unsubstituted alkyl group, a substituted or unsubstituted alkoxy group, a substituted or unsubstituted cycloalkyl group, a substituted or unsubstituted aryl group, and a substituted or unsubstituted heterocyclic group.

2. The photosensitive resin composition of claim 1, wherein the green colorant includes one kind or more selected from the group consisting of a phthalocyanine green (C.I. 74260) and a C.I. PIGMENT Green 7.

3. The photosensitive resin composition of claim 1, wherein the yellow colorant includes a C.I. PIGMENT Yellow 129.

4. The photoresist resin composition of claim 1, wherein the blue dispersing aid includes a copper phthalocyanine-based compound.

5. The photoresist resin composition of claim 1, wherein the colorant composition further includes one kind or more selected from the group consisting of a second binder resin, a dispersant, and a second solvent.

6. The photoresist resin composition of claim 5, wherein a total content of the green colorant, the yellow colorant, and the blue dispersing aid is 12 to 15 wt% based on a total weight of the colorant composition.

7. The photoresist resin composition of claim 6, wherein a content of the blue dispersing aid is 5 to 20 wt% based on a total weight of the green colorant, the yellow colorant, and the blue dispersing aid.

8. The photoresist resin composition of claim 1, wherein a weight ratio of the green colorant to the yellow colorant is in a range of 1 : 9 to 9 : 1.

9. The photoresist resin composition of claim 1, wherein Gx and Gy of a color coordinate (Gx, Gy) of a color filter pattern manufactured by using the photosensitive resin composition are in a range of 0.2 to 0.21 and 0.68 to 0.7, respectively.

10. The photoresist resin composition of claim 9, wherein a thickness of the color filter pattern is 2.0 to 2.5 µm.

11. The photosensitive resin composition according to claim 1, further comprising:
one kind or more selected from the group consisting of a curing accelerator, a thermal polymerization inhibitor, a surfactant, a photosensitizer, a plasticizer, an adhesion promotor, and a filler.

12. A color filter formed by using the photosensitive resin composition of any one of claims 1 to 11.

13. The color filter of claim 12, wherein the color filter includes a green color filter pattern.

14. The color filter of claim 13, wherein Gx and Gy of a color coordinate (Gx, Gy) of the green color filter pattern is in a range of 0.2 to 0.21 and 0.68 to 0.7, respectively.

15. The color filter of claim 14, wherein a thickness of the green color filter pattern is 2.0 to 2.5 µm.
